# EUROPÄISCHE PATENTANMELDUNG

(11) **EP 3 543 717 A1**
(43) Veröffentlichungstag der Anmeldung: **25.09.2019**
(21) Anmeldenummer: 18163284.5
(22) Anmeldetag: 22.03.2018
(51) Int. Cl.: G01R 29/08

(54) **PERSONENSCHUTZ-MESSGERÄT**

(71) Anmelder: Narda Safety Test Solutions GmbH, 72793 Pfullingen (DE)
(72) Erfinder: Späth, Michael, 72793 Pfullingen (DE); Heusel, Johannes, 72116 Mössingen (DE)
(74) Vertreter: Klocke, Peter

(57) **Zusammenfassung**

Personenschutz-Messgerät (1) zum Schutz von Personen in elektromagnetischen Feldern mit einer Sensoreinheit (3) mit einem oder mehreren Sensorelementen als E-Feld-und/oder H-Feld-Sensoren, einer elektronischen Steuer- und Auswerteeinheit (5) und eine Anzeige (4), wobei die Sensoren in Reihe geschaltete Widerstände und Dioden aufweisen, wobei eine Testeinrichtung (5, 6, 7) für die Überprüfung der Funktionstüchtigkeit der Sensorelemente unabhängig von externen umgebenden elektromagnetischen Feldern vorgesehen ist.

## Beschreibung

Die vorliegende Erfindung betrifft ein Personenschutz-Messgerät zum Schutz von Personen in elektromagnetischen Feldern mit einer Sensoreinheit mit einem oder mehreren Sensorelementen als E-Feld- und/oder H-Feld-Sensoren, einer elektronischen Steuer- und Auswerteeinheit und einer Anzeige, wobei die Sensoren in Reihe geschaltete Widerstände und Dioden aufweisen. Die Erfindung betrifft außerdem ein Verfahren zum Betreiben eines derartigen Personenschutz-Messgeräts.

Für den Schutz und die Sicherheit am Arbeitsplatz existieren Gesetze sowie nationale Vorschriften und Empfehlungen, die Expositionsgrenzwerte für die in den elektromagnetischen Feldern tätigen Personen vorsehen. Hierzu gibt es jeweils für den Einsatz und die Branche passende Messgeräte. Je nach Anwendungsfall werden sogenannte Breitbandmessgeräte oder persönliche Monitore eingesetzt, die wie eingangs ausgeführt ausgestaltet sind. Es sind Personenschutz-Messgeräte bekannt, die entweder die elektrischen Felder (E-Feld) oder die magnetischen Felder (H-Feld) getrennt in unterschiedlichen Frequenzbereichen messen. Diese Messgeräte sind üblicherweise kompakte Handmessgeräte mit einer in der Hand zu haltenden Messgerätegehäuse, in dem sich die eine Mess- und Auswerteelektronik mit Speichermittel, optischer und/oder akustischer Anzeige und Bedienelemente befinden und an die je nach Anwendungsfall geeignete Sensoren angeschlossen werden können. Derartige Personenschutz-Messgeräte werden üblicherweise gezielt eingesetzt, um einen gewissen Bereich auf vorhandene E-Feld und/oder H-Feld-Belastungen zu untersuchen. Auch gibt es Messgeräte, die, insbesondere auch als akute handliche Warngeräte (Monitoren) am Körper getragen, bei der Arbeit sowohl vor zu hohen elektrischen als auch magnetischen Feldern warnen, somit sowohl das E-Feld und das H-Feld messen. Bei diesen Geräten sind die Sensoren in dem Messgerätgehäuse integriert. Neben der Verwendung als am Körper getragenes Warngerät können derartige Personenschutz-Messgeräte außerdem als Überwachungsgerät verwendet werden, um, wie auch die vorstehend genannten Geräte, den Aufenthaltsbereich von Personen vorab auf die Einhaltung von Grenzwerten zu überprüfen. Des Weiteren kann ein derartiges Gerät aufgrund seiner baulich kleinen Ausgestaltung auch zur Leckstellensuche an Hohlleiter- und Koax-Schraubverbindungen eingesetzt werden.

Die Aufgabe der Sensoren und der Sensoreinheit ist es, das einfallende Feld zu detektieren und in eine messbare Gleichspannung umzuwandeln. Hierzu werden Antennenelemente (Detektoren) mit Dioden (Gleichrichter) verschaltet. Ein besonderes Problem dieser Geräte ist, dass die Sensorelemente in der Sensoreinheit durch zu hohe Exposition in entsprechenden Feldern durchbrennen oder durch mechanische Belastungen beschädigt werden können. Sind die Sensoren einmal beschädigt, zeigen die Geräte nicht mehr richtig an und es besteht die Gefahr, dass die zu schützenden Personen unzulässig hohen elektromagnetischen Feldern ausgesetzt werden. Um dieses Risiko auszuschließen, wird bisher empfohlen, vor einem Messeinsatz die Sensoren einem Referenzfeld mit bekannter Feldstärke auszusetzen und zu prüfen, ob das Gerät diesen Referenzwert tatsächlich anzeigt. Dieses Verfahren ist sehr aufwendig, da zum einen eine Referenzquelle mitgeführt werden muss und dieses Verfahren voraussetzt, dass der Sensor nur dem Referenzfeld und nicht etwa anderen von außen einwirkenden Feldern ausgesetzt ist, also geschirmt werden muss. Gerade die notwendige Schirmung zu gewährleisten, macht diese vorherige Prüfung umständlich und aufwändig.

Der vorliegenden Erfindung liegt daher die Aufgabe zugrunde, ein Personenschutz-Messgerät vorzuschlagen, welches dem Nutzer vor Ort in realer Umgebung ohne zusätzliche Schirmmaßnahmen die wiederholte Prüfung des Messgeräts auf korrekte Funktion erlaubt.

Diese Aufgabe wird erfindungsgemäß durch ein Personenschutz-Messgerät gemäß Anspruch 1 gelöst. Weitere vorteilhafte Ausgestaltungen sind den rückbezogenen Unteransprüchen zu entnehmen. Die Aufgabe wird außerdem durch ein Verfahren zum Betreiben eines derartigen Personenschutz-Messgeräts gelöst.

Danach ist eine Testeinrichtung für die Überprüfung der Funktionstüchtigkeit der Sensorelemente unabhängig von externen umgebenden elektromagnetischen Feldern vorgesehen. Je nach Ausgestaltung des Personenschutz-Messgeräts kann die Testeinrichtung in dem Gehäuse des Messgeräts oder auch in der an das Messgerätgehäuse anzuschließenden Messsonde integriert sein. Damit die Testeinrichtung für die Überprüfung der Funktionstüchtigkeit der Sensorelemente unabhängig von externen umgebenden elektromagnetischen Feldern die Überprüfung vornehmen kann, ist es erforderlich, dass die Testeinrichtung mit Signalen arbeitet, die deutlich von den Messsignalen unterschieden werden können.

Gemäß einer bevorzugten Ausbildung des Personenschutz-Messgeräts weist die Testeinrichtung einen Signalgenerator zur Erzeugung eines Testsignals an einem oder mehreren Sensorelementen (nachfolgend vereinfachend als Sensoreinheit bezeichnet) auf. Im einfachsten Fall ist das Testsignal eine Gleichspannung. Es kann aber auch als gepulstes, moduliertes, codiertes, getaktetes Signal oder als Wechselspannung ausgeführt sein. Das an die Sensoreinheit angelegte Testsignal wird im Falle einer Beschädigung durch die Sensoreinheit derart verändert, dass über die Auswerteeinrichtung, in der je nach Testsignal ein Referenzsignal oder Referenzwert, vorzugsweise gerätespezifisch, in einem Speicher hinterlegt ist, auf den Zustand der Sensoreinheit geschlossen werden kann. Das Testsignal wird direkt an die Sensoreinheit angelegt. Da üblicherweise die Sensoren entweder komplett (E-Feldsensor) oder zu weiten Teilen (H-Feld-Sensoren) aus in Reihe geschalteten Widerständen und Dioden bestehen, kann im einfachsten Fall unter Verwendung einer Gleichspannung als Testsignal anhand der detektierten Testspannung aufgrund des Spannungsabfalls über die Sensoreinheit auf deren Zustand wie Unterbrechungen oder Kurzschlüsse in einer mehreren Dioden geschlossen werden. Dadurch können Defekte in der Sensoreinheit, weiche durch Erschütterungen oder zu hohe mechanische Belastungen (Unterbrechungen) oder durch zu starke elektromagnetische Felder (Kurzschlüsse in den Dioden) entstanden sind, erkannt werden. Die Überprüfung eines E-und H-Feld-Sensors unterscheidet sich nur durch die Höhe der Testspannung. Der Vergleich des Testsignals an dem einen oder mehreren Sensorelementen mit einem gespeicherten Referenzsignal oder Referenzwert erfolgt mittels der Steuer-und Auswerteeinheit, die für diesen Zweck als Auswerteeinrichtung dient.

Zweckmäßigerweise weist das Testsignal eine Charakteristik auf, die sich von der von dem elektromagnetischen Feld generierten Sensorspannung unterscheidet. Abhängig von der Art des Testsignals kann es Spannungshöhe, die Frequenz oder auch eine digitale Codierung des Testsignals sein. Das von dem Signalgenerator abgegebene Testsignal ist im Falle einer Gleichspannung vielfach größer als die von dem elektromagnetischen Feld generierte Sensorspannung, so dass die Überprüfung der Funktionstüchtigkeit auch dann durchgeführt werden kann, wenn sich das Gerät bereits in einem Bereich erhöhter Feldstärke befindet.

Da der Unterschied im Spannungsabfall bei einer kurz geschlossenen Diode nur einige Millivolt beträgt und die Spannungsunterschiede durch Bauteiltoleranzen größer sein können, ist vorteilhafter Weise das Referenzsignal oder der Referenzwert gerätespezifisch und wird bei der Inbetriebnahme des Personenschutz-Messgeräts ermittelt und in einem Gerätespeicher abgelegt.

Gemäß einer weiteren bevorzugten Ausbildung des Personenschutz-Messgeräts ermittelt die Steuer- und Auswerteeinheit den aktuellen Gerätezustand, vorzugsweise nach dem Einschalten des Personenschutz-Messgeräts. Hierzu veranlasst die Steuer- und Auswerteeinheit die Messung der aktuellen Feldstärke, des unbelasteten Testsignals und gegebenenfalls die aktuelle Temperatur, die zur Temperaturkompensation notwendig sein kann. Vorzugsweise nach der Feststellung des aktuellen Gerätezustands, jedoch nicht zwingend erforderlich, wird gemäß einer zweckmäßigen Ausbildung des Personenschutz-Messgeräts durch die Steuer- und Auswerteeinheit über die Testeinrichtung ein Testsignal an die Sensoreinheit angelegt und ein davon abhängiges Signal bzw. ein davon abhängigen Signalwert wie vorstehend ausgeführt ermittelt.

Die Steuer- und Auswerteeinheit vergleicht das ermittelte Signal bzw. den ermittelten Signalwert mit dem abgespeicherten Referenzsignal bzw. Referenzsignalwert von der Sensoreinheit und bewirkt gemäß einer bevorzugten Ausbildung des Personenschutz-Messgeräts abhängig von dem Vergleich entweder den Start des normalen Messbetriebs oder ein Abschalten des Personenschutz-Messgeräts. Der Vergleich kann gegebenenfalls mit der Temperaturkompensation durchgeführt werden. Damit wird dem Benutzer sicher übermittelt, wenn eine Störung des Personenschutz-Messgeräts vorliegt.

Vorzugsweise veranlasst die Steuer- und Auswerteeinheit vor dem Abschalten die Ausgabe eines definierten Signals akustisch und/oder optisch mittels einer entsprechenden Anzeigeeinrichtung und vorzugsweise einen Eintrag in einen, vorzugsweise internen, Datenlogger mit den Messwerten aus der Überprüfung der Sensoreinheit.

Zweckmäßigerweise wird das Testsignal vor der Durchführung einer Messung der elektrischen/magnetischen/elektromagnetischen Felder durchgeführt, um dem Bediener vor der Inbetriebnahme die Gewissheit zu geben, dass das Personenschutz-Messgerät einwandfrei funktioniert. Es ist auch möglich, während eines Messvorgangs der Felder diesen zu unterbrechen und einen Test der Funktionsfähigkeit der Sensoreinheit zwischendurch durchzuführen und anschließend die Messung mit dem Personenschutz-Messgerät fortzusetzen. Dies kann automatisch zeitgesteuert oder abhängig von vorgegebenen Spitzenwerten der gerade erfolgten Messung der Felder oder manuell durch den Benutzer erfolgen.

Gemäß einer bevorzugten Ausbildung des Personenschutz-Messgeräts weist die Testeinrichtung einen Spannungsgenerator zur Erzeugung einer Testspannung an einem oder mehreren Sensorelementen sowie eine Auswerteeinrichtung zum Vergleich des Spannungsabfalls über das eine Sensorelement oder die mehreren Sensorelemente mit einem gespeicherten Referenzspannungswert auf. Hierbei handelt es sich um die einfachste zu realisierende Möglichkeit, wobei vorteilhafterweise die Testspannung eine Spannungshöhe aufweist, die von der von dem elektromagnetischen Feld generierten Sensorspannung sich deutlich unterscheidet.

Gemäß dem Verfahren zum Betreiben des Personenschutz-Messgeräts wird in einer bevorzugten Ausgestaltung nach dem Einschalten des Personenschutz-Messgeräts der Gerätezustand bezüglich der aktuellen Feldstärke, der Testspannung im Leerlauf und gegebenenfalls die aktuelle Temperatur ermittelt, anschließend die Testspannung an einem oder mehreren Sensorelementen angelegt und gemessen und mit einer oder mehreren Referenzspannungen verglichen, und abhängig vom Vergleichsergebnis der normalen Messbetrieb gestartet oder das Gerät abgeschaltet. Wie bereits ausgeführt, kann auch die Überprüfung des Gerätezustands weggelassen werden oder eine Überprüfung auf Funktionsfähigkeit während einer Feldmessung erfolgen.

Die vorliegende Erfindung ermöglicht somit eine automatische Prüfung, sodass das Mitführen einer Referenzquelle und das Prüfen des Personenschutz-Messgeräts in geschirmter Umgebung sich erübrigt. Dies stellt eine erhebliche Erleichterung und höhere Zuverlässigkeit der Messung von elektromagnetischen Feldern dar, wobei dies unabhängig von den umgebenden elektromagnetischen Feldern erfolgen kann.

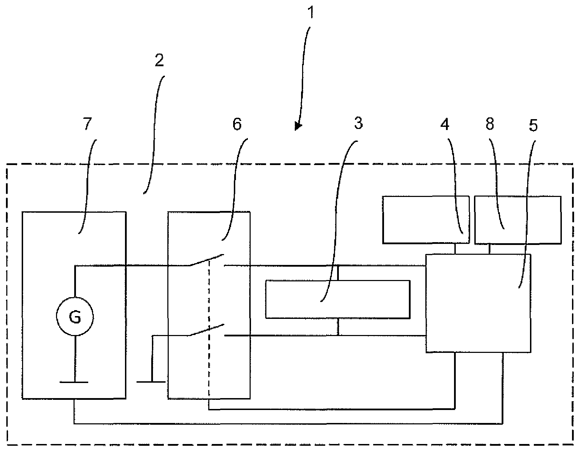

Die vorstehend in der Beschreibung genannten Merkmale und Merkmalskombinationen sowie die nachfolgend in der Figurenbeschreibung genannten und/oder in den Figuren alleine gezeigten Merkmale und Merkmalskombinationen sind nicht nur in der jeweils angegebenen Kombination, sondern auch in anderen Kombinationen oder in Alleinstellung verwendbar. Sämtliche aus den Ansprüchen, der Beschreibung oder der Zeichnung hervorgehenden Merkmale und/oder Vorteile, einschließlich konstruktive Einzelheiten, räumliche Anordnung und Verfahrensschritte können sowohl für sich als auch in den verschiedensten Kombinationen erfindungswesentlich sein. Zur Ausführung der Erfindung müssen nicht alle Merkmale des Anspruchs 1 verwirklicht sein. Auch können einzelne Merkmale der unabhängigen oder nebengeordneten Ansprüche durch andere offenbarte Merkmale oder Merkmalskombinationen ersetzt werden.

Nachfolgend wird die Erfindung anhand einer einzelnen Figur kurz erläutert. Die Figur zeigt als schematisches Blockschaltbild den Aufbau, wie er beispielsweise in einem Personenschutz-Messgerät 1 in Form eines persönlichen am Körper getragenen Monitors realisiert sein kann. Bei diesem Ausführungsbeispiel ist in einem gestrichelt dargestellten Gehäuse 2 neben der aus mehreren Sensorelementen bestehenden Sensoreinheit 3 und der von Haus aus vorhandenen Steuer- und Auswerteeinheit 5 sowie optische Anzeige 4 ein Testsignal-Generator 7 mit zugehöriger Schalteinrichtung 6 integriert und elektrisch miteinander verbunden. Die Sensoreinheit 3 umfasst in bekannter Art und Weise in diesem Ausführungsbeispiel einen E-Feld-Sensor und einen H-Feld-Sensor, die jeweils dreiachsig (isotrop) aufgebaut sind. Jeweils alle drei Achsen sind in Reihe geschaltet und weisen in Reihe geschaltete Widerstände und Dioden auf. Die Steuer- und Auswerteeinheit umfasst selbst verständlich auch Bedienelemente, sofern diese nicht über die Anzeige realisiert sind sowie geeignete Speichermittel. Für die Überprüfung des Personenschutz-Messgerätes 1 auf Funktionsfähigkeit ist eine Testeinrichtung vorgesehen, die in dem Ausführungsbeispiel aus dem Test Signalgenerator 7, dem Schalter 6 sowie der Steuer- und Auswerteeinheit 5 als Auswerteeinrichtung besteht. In dem Ausführungsbeispiel liefert der Testsignal-Generator 7 eine Gleichspannung, die über den Schalter 6 an die Sensoreinheit 3 angelegt wird. Die auch mit dem Testsignal-Generator 7 und der Schaltereinrichtung 6 verbundene Steuer- und Auswerteeinheit 5 vergleicht die an der Sensoreinheit 3 anliegende Spannung mit einer abgespeicherten Referenzspannung, um festzustellen, ob eine Beschädigung der Sensoreinheit 3 vorliegt. Sofern die Spannung an der Sensoreinheit 3 innerhalb eines bestimmten vorgegebenen Bereichs im Vergleich zu der gespeicherten Referenzspannung liegt, wird nach Berücksichtigung einer Einschwingzeit der normale Messbetrieb gestartet. Wenn die Spannung an der Sensoreinheit 3 im Vergleich zu der Referenzspannung zu hoch ist, ist davon auszugehen, dass eine Unterbrechung vorliegt, im anderen Fall ein Kurzschluss einer oder mehrerer Dioden. Beides führt dazu, dass ein definierter Signalton über einen akustischen Signalgeber 8 abgegeben wird. Außerdem erfolgt eine Eintragung in einem in der Steuer-und Auswerteeinheit 5 integrierten Datenspeicher (Datenlogger) mit den Messwerten aus der Überprüfung (Sensorspannung vor der Überprüfung, Prüfspannung unbelastet/belastet, Temperatur). Anschließend schaltet sich das Personenschutz-Messgerät 1 ab.

## Patentansprüche

1. Personenschutz-Messgerät (1) zum Schutz von Personen in elektromagnetischen Feldern mit einer Sensoreinheit (3) mit einem oder mehreren Sensorelementen als E-Feld-und/oder H-Feld-Sensoren, einer elektronischen Steuer- und Auswerteeinheit (5) und einer Anzeige (4, 8), wobei die Sensoren in Reihe geschaltete Widerstände und Dioden aufweisen, **gekennzeichnet durch** eine Testeinrichtung (5, 6, 7) für die Überprüfung der Funktionstüchtigkeit der Sensorelemente unabhängig von externen umgebenden elektromagnetischen Feldern.

2. Personenschutz-Messgerät (1) nach Anspruch 1, **dadurch gekennzeichnet, dass** die Testeinrichtung einen Signalgenerator (7) zur Erzeugung eines Testsignals an der Sensoreinheit (3) sowie eine Auswerteeinrichtung zum Vergleich des Testsignals an der Sensoreinheit (3) mit einem gespeicherten Referenzsignal oder Referenzwert aufweist.

3. Personenschutz-Messgerät (1) nach Anspruch 2, **dadurch gekennzeichnet, dass** das Testsignal eine Charakteristik aufweist, die sich von der von dem elektromagnetischen Feld generierten Sensorspannung unterscheidet.

4. Personenschutz-Messgerät (1) nach Anspruch 2 oder Anspruch 3, **dadurch gekennzeichnet, dass** das Referenzsignal oder der Referenzwert gerätespezifisch ist.

5. Personenschutz-Messgerät (1) nach einem der vorangegangenen Ansprüche, **dadurch gekennzeichnet, dass** die Steuer- und Auswerteeinheit (5), vorzugsweise nach dem Einschalten des Geräts, zur Feststellung des aktuellen Gerätezustands die aktuelle Feldstärke, das unbelastete Testsignal und gegebenenfalls die aktuelle Temperatur ermittelt.

6. Personenschutz-Messgerät (1) nach einem oder mehreren der vorangegangenen Ansprüche, **dadurch gekennzeichnet, dass** die Steuer- und Auswerteeinheit (5), vorzugsweise nach der Feststellung des aktuellen Gerätezustands, über die Testeinrichtung (5, 6, 7) ein Testsignal an die Sensoreinheit (3) anlegt und ein davon abhängiges Signal bzw. einen davon abhängigen Signalwert ermittelt.

7. Personenschutz-Messgerät (1) nach Anspruch 6, **dadurch gekennzeichnet, dass** die Steuer- und Auswerteeinheit (5) das ermittelte Signal bzw. den ermittelten Signalwert mit dem abgespeicherten Referenzsignal bzw. Referenzsignalwert von der Sensoreinheit (3) vergleicht, gegebenenfalls mit Temperaturkompensation, und abhängig von dem Vergleich entweder den normalen Messbetrieb startet oder das Personenschutz-Messgerät (1) abschaltet.

8. Personenschutz-Messgerät (1) nach Anspruch 7, **dadurch gekennzeichnet, dass** die Steuer- und Auswerteeinheit (5) vor dem Abschalten die Ausgabe eines definierten Signals akustisch und/oder optisch veranlasst und vorzugsweise einen Eintrag in einen, vorzugsweise internen, Datenlogger mit den Messwerten aus der Überprüfung von der Sensoreinheit (3), veranlasst.

9. Personenschutz-Messgerät (1) nach einem oder mehreren der vorangegangenen Ansprüche, **dadurch gekennzeichnet, dass** die Testeinrichtung (5, 6, 7) einen Spannungsgenerator (7) zur Erzeugung einer Testspannung an der Sensoreinheit (3) sowie eine Auswerteeinrichtung (5') zum Vergleich des Spannungsabfalls über der Sensoreinheit (3) mit einem gespeicherten Referenzspannungswert aufweist.

10. Personenschutz-Messgerät (1) nach Anspruch 9, **dadurch gekennzeichnet, dass** die Testspannung eine Spannungshöhe aufweist, die von der von dem elektromagnetischen Feld generierten Sensorspannung sich unterscheidet.

11. Verfahren zum Betreiben eines Personenschutz-Messgeräts (1) nach einem der Ansprüche 1 bis 4, **dadurch gekennzeichnet, dass** nach dem Einschalten des Personenschutz-Messgeräts (1) der Gerätezustand bezüglich der aktuellen Feldstärke, der Testspannung im Leerlauf und gegebenenfalls die aktuelle Temperatur ermittelt, anschließend die Testspannung an der Sensoreinheit (3) angelegt und gemessen und mit einer oder mehreren Referenzspannungen verglichen, und abhängig vom Vergleichsergebnis der normalen Messbetrieb gestartet oder das Personenschutz-Messgerät (1) abgeschaltet wird.
